# NOUVEAU FASCICULE DE BREVET EUROPEEN

(11) **EP 0 297 991 B2**
(45) Date de publication et mention de la décision concernant l'opposition: **04.10.1995**
(45) Mention de la délivrance du brevet: 25.03.1992
(21) Numéro de dépôt: 88401699.9
(22) Date de dépôt: 01.07.1988
(51) Int. Cl.: H01L 23/48, H01L 21/50, G06K 19/067, G06K 19/077

(54) **Procédé de fabrication d'une carte à microcircuits électroniques**
Verfahren zum Herstellen einer elektronischen Mikroschaltungskarte
Method of fabricating an electronic microcircuit card

(30) Priorité: 02.07.1987 FR 8709380
(43) Date de publication de la demande: 04.01.1989
(73) Titulaire: CP8 Transac, 78430 Louveciennes (FR)
(72) Inventeur: Champagne, Daniel, F-78790 Septeuil (FR); Le Loc'h, Alain, F-78000 Versailles (FR)
(74) Mandataire: Corlu, Bernard Edouard

(56) Documents cités:
- EP-A- 0 140 230
- WO-A-87/00486
- FR-A- 2 523 335
- FR-A- 2 575 567
- IEEE INTERNATIONAL ELECTRONIC MANUFACTURING TECHNOLOGY SYMPOSIUM, San Francisco, 15-17 septembre 1986, pages 30-33, IEEE; M. OHUCHI et al.: "A new LSI interconnection method for IC card"

## Description

L'invention se rapporte à une carte à microcircuits électroniques et à son procédé de fabrication. Elle s'applique plus particulièrement à la fabrication d'une carte portative dont l'épaisseur satisfait aux normes ISO (International Standard Organisation) des cartes de crédit.

Une carte à microcircuits électroniques est une plaquette rectangulaire monobloc ou multicouche en matériau plastique, qui incorpore des microcircuits électroniques et présente extérieurement des contacts pour la connexion des microcircuits électroniques avec un appareil de traitement de cartes. Ces microcircuits peuvent être destinés à des fonctions très diverses, telles que par exemple les opérations bancaires de débit et de crédit, l'allocation d'unités téléphoniques et l'entrée confidentielle dans un milieu protégé. Ils constituent généralement des circuits de traitement et/ou de mémoire plus ou moins complexes selon l'usage auquel ils sont destinés. Dans la pratique, ils sont formés sur au moins une plaquette de silicium appelée couramment circuit intégré, puce ou chip.

L'invention s'applique notamment à une carte telle que décrite par exemple dans le brevet français n° 2 337 381 de la demanderesse (U.S. patents No. 4 216 577 et No. 4 222 516). Un circuit imprimé a une face pourvue d'un circuit intégré et l'autre face présentant les contacts de la carte. Selon un exemple de réalisation, la carte est simplement faite d'une plaquette monobloc, dont une face présente graduellement, à partir d'une cavité profonde, une zone de renfoncement périphérique et un palier entourant la zone de renfoncement. Le circuit intégré est logé dans la cavité et le circuit imprimé est étalé sur la zone de renfoncement. Une feuille recouvrant le circuit imprimé et formant ainsi un couvercle est fixée au palier. La feuille a sa face extérieure sensiblement coplanaire avec la face correspondante de la plaquette et comporte des ouvertures en correspondance avec les contacts du circuit imprimé. L'exploitation de la carte se fait donc par connexion des contacts à travers les ouvertures de la feuille.

Selon une variante de réalisation décrite dans le brevet antérieur cité, la plaquette n'a pas de palier de renfoncement et la feuille de recouvrement du circuit imprimé recouvre toute la face correspondante de la plaquette. La carte est ainsi faite de la plaquette et de la feuille. Les contacts restent accessibles au travers d'ouvertures dans la feuille.

Une autre variante de réalisation est décrite par exemple dans la demande de brevet européen n° 0 207 852 de la demanderesse. Le circuit imprimé est fait d'une bande mince, dont l'extrémité d'une face porte le circuit intégré et l'autre extrémité de l'autre face présente les contacts de la carte. Ainsi, les contacts sont décalés relativement au circuit intégré. Cette disposition peut être préférée pour plusieurs raisons, notamment celle visant à satisfaire les normes d'emplacement des contacts sur la grande médiane de la carte. Grâce au circuit imprimé à contacts décalés, le circuit intégré peut demeurer dans un coin de la carte où les contraintes à la flexion et à la torsion sont nettement plus faibles qu'au niveau des contacts. Cependant, la réalisation simple et à bas prix du circuit imprimé impose qu'il soit recouvert par une feuille pourvue d'ouvertures en correspondance avec les contacts. La feuille peut seulement être un couvercle ou s'étendre sur toute la face de la plaquette.

Ces exemples de réalisation prouvent que souvent la fabrication d'une carte à microcircuits électroniques requiert l'emploi d'une feuille pourvue d'ouvertures pour l'accès aux contacts de la carte portés par le circuit imprimé. L'épaisseur de la feuille pour accéder aux contacts présente plusieurs inconvénients. D'une part de nombreuses applications de la carte nécessitent l'adjonction d'une pellicule d'apprêt à la feuille. D'autre part, pour donner à la feuille une bonne résistance mécanique pour la protection du circuit imprimé, la feuille doit avoir une épaisseur minimale relativement élevée. Il s'ensuit que les contacts se trouvent à une profondeur relativement grande de la surface de la carte, par exemple supérieure à 0,1 millimètre. Compte tenu des divers modes de fabrication des cartes pouvant être exploitées sur un appareil, le connecteur de cet appareil devrait s'adapter à une grande marge possible de profondeurs tout en assurant une connexion efficace et fiable. Des normes ont été édictées pour limiter la profondeur maximale des contacts à une valeur relativement faible. Le problème s'est donc posé de rehausser les contacts dans les ouvertures pour satisfaire aux normes et, si possible, mettre les contacts pratiquement au niveau de la surface de la carte.

Une solution connue, décrite par exemple dans la demande de brevet internationale publiée sous le numéro WO-A-87/00486, pour rehausser les contacts dans les ouvertures consiste à faire une surcroissance de cuivre sur les plages des contacts qui sont en correspondance avec les ouvertures. Cette surcroissance est faite en général par dépôt électrochimique de cuivre, qui requiert l'emploi d'une technologie peu utilisée, longue et coûteuse.

Une autre solution est connue du document EP-A-0.140.230, selon laquelle la plaquette ou support de la carte à microcircuits est chauffée puis pressée en même temps que le circuit imprimé et la feuille de recouvrement de celui-ci de façon à provoquer, par déformation à chaud de la plaquette, l'enfoncement du circuit imprimé dans la plaquette et l'émergence de bosses aux endroits où la feuille de recouvrement présente des ouvertures. Un inconvénient de cette solution est qu'en raison de la nature plastique de la feuille de recouvrement, celle-ci se déforme durant le pressage de sorte que l'on n'obtient pas une définition précise des bords de ces ouvertures, donc des contacts.

L'inventeur vise à proposer une solution pour réhausser les contacts par déformation à chaud, permettant toutefois d'obtenir une bonne définition du produit fini. Cette solution fait l'objet de la revendication 1 ci-jointe.

Les caractéristiques et avantages de l'invention ressortiront de la description qui suit, donnée à titre d'exemple et faite en référence aux dessins annexés.

Dans les dessins :
- la figure 1 est une vue en coupe partielle suivant la ligne I-I indiquée à la figure 2, illustrant un mode de réalisation d'une carte conforme à l'invention ;
- la figure 2 est une vue de dessus avec arrachement partiel de la carte représentée en partie sur la figure 1 ;
- les figures 3A à 3E sont des vues en coupe illustrant des étapes pour la fabrication de la carte représentée sur les figures 1 et 2 ;
- la figure 4 est une vue similaire à celle de la figure 1, illustrant une première variante de réalisation d'une carte conforme à l'invention ;
- la figure 5 est une vue similaire à celle la figure 1, illustrant une seconde variante de réalisation d'une carte conforme à l'invention ;
- la figure 6 est une vue similaire à celle de la figure 1, illustrant une troisième variante de réalisation d'une carte conforme à l'invention.

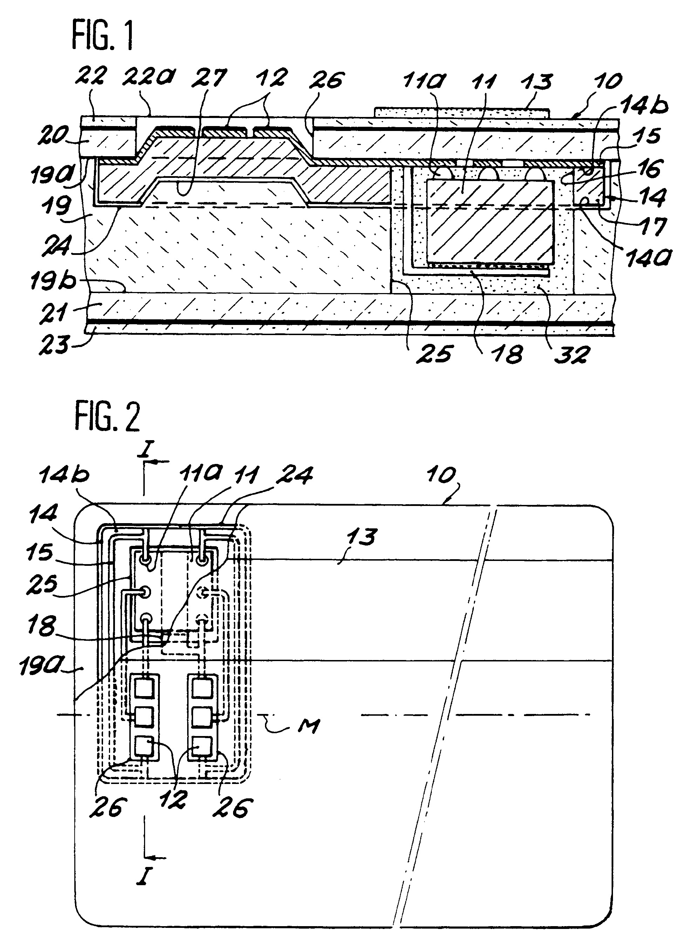

Les Figures 1 et 2 illustrent le mode préféré de réalisation d'une carte à microcircuits électroniques 10 conforme à l'invention, du type carte de crédit normalisée. Les microcircuits électroniques sont supposés inclus dans un seul circuit intégré 11 et accessibles par six plots 11a. Une face de la carte 10 de forme rectangulaire présente six contacts 12 pour la connexion du circuit intégré 11 à un appareil de traitement de cartes non représenté. La même face de la carte comporte une bande magnétique de support d'information 13. Selon les normes choisies comme exemple, la bande magnétique 13 est proche d'un grand côté de la carte et les contacts 12 sont placés dans une zone coupant ou avoisinant la grande médiane M de la carte à proximité d'un petit côté.

De manière classique, la carte 10 inclut un circuit imprimé 14 dont une face 14a porte le circuit intégré 11 et l'autre face 14b présente les contacts 12. Des conducteurs 15 sur la face 14b relient respectivement les six contacts 12 aux six plots 11a du circuit intégré 11 selon la technologie bien connue TAB (Tape Automated Bonding). Ainsi, les plots 11a du circuit intégré 11 sont soudés aux extrémités montées en porte-à-faux des conducteurs 15 autour d'une fenêtre 16 du substrat isolant 17 du circuit imprimé 14. Le substrat 17 est habituellement un matériau plastique tel que celui connu sous la marque déposée "Kapton", de l'ordre de 130 micromètres (µm). Les contacts 12 et les conducteurs 15 sont ordinairement faits à partir d'une même couche métallique de cuivre appliquée sur le substrat 16 du circuit imprimé. Les contacts 12 sont ensuite formés par dépôt d'une couche d'or sur au moins une couche intermédiaire de compatibilité, l'ensemble de ces couches étant représenté par un trait fort sur la figure 1. En supposant que le circuit intégré 11 est du type MOS (Métal Oxyde Semiconducteur), l'un des conducteurs 15 se prolonge par une patte de polarisation 18 fixée à la face arrière du circuit intégré, par exemple par une colle conductrice à base d'argent. Le circuit imprimé 14 représenté est donc du type à contacts décalés.

De manière classique également, la carte 10 est supposée être formée d'une plaquette centrale 19, appelée aussi âme, dont les deux grandes faces 19a, 19b sont respectivement recouvertes de deux feuilles 20, 21 et de deux pellicules 22, 23. La plaquette et les deux feuilles sont généralement faites d'un matériau plastique souple tel que le PVC (chlorure de polyvinyle). Les feuilles sont d'égale épaisseur et sont minces par rapport à la plaquette, selon par exemple le rapport 130µm/500µm. Dans de nombreuses utilisations, les feuilles sont imprimées pour y lire toutes les informations désirées telles que le nom et l'adresse du titulaire de la carte, le nom de la société de service,... Un trait fort illustre l'impression faite sur les faces extérieures des deux feuilles 20, 21 de la figure 1. Les deux pellicules 22, 23 sont généralement requises pour la protection de l'impression et pour l'aspect extérieur de la carte. Ces pellicules sont ordinairement faites d'un cristal transparent de PVC rendant la carte glacée, et ont une épaisseur de l'ordre de 25µm. Ordinairement, les deux feuilles sont recouvertes de leurs pellicules respectives, puis sont appliquées et fixées à la plaquette par thermocompression. Par conséquent, le terme feuille s'étend généralement à la feuille pourvue de sa pellicule et doit être ainsi compris dans le sens général du mot tel que mentionné dans les revendications, notamment.

Toujours de manière classique, le circuit imprimé 14 est inséré entre la plaquette 19 et la feuille 20. La face 19a de la plaquette 19 présente une zone 24 recouverte par la face 14a du circuit imprimé 14, et une cavité 25 pour loger le circuit intégré 11. Dans l'exemple illustré, la cavité 25 est un trou traversant la plaquette 19. La feuille 20 recouvre le circuit imprimé 14 et comporte des ouvertures 26 en correspondance avec les contacts 12. Dans l'exemple illustré, seulement deux ouvertures 26 sont ménagées pour donner accès chacune à un groupe de trois contacts 12. Dans la technique antérieure, le circuit imprimé 14 reposait sur la zone 24 faite uniformément plane. De la sorte, les contacts 12 se plaçaient approximativement au niveau de la face 1 9a de la plaquette 19. Dans ces conditions, les contacts n'étaient accessibles qu'à travers toute l'épaisseur de la feuille 20 et de la pellicule 22, faisant au total 155µm environ. Une telle profondeur étant inadmissible, le problème était de rehausser les contacts 12 dans les ouvertures 26 pour les rapprocher de la surface extérieure 22a de la carte et, si possible, de les mettre à ce niveau.

Selon l'invention, la zone 24 comporte une bosse 27 sous chacune des deux ouvertures 26. La hauteur de la bosse aura de préférence l'épaisseur de la feuille 20 et éventuellement de la pellicule 22 pour mettre les contacts 12 au niveau de la face 22a de la carte 10.

La bosse 27 représentée est commune aux trois contacts 12 inclus dans chaque ouverture 26. Naturellement, une seule bosse suffirait si tous les contacts 12 étaient indus dans une même ouverture 26.

Il est clair que cette bosse 27 peut être formée sur la plaquette 19 préalablement au montage du circuit imprimé 14. Par exemple, la plaquette 19 peut être moulée pour obtenir une zone 24 pourvue de deux bosses 27. Le trou 25 pourrait être fait pendant ou après le moulage. Le circuit imprimé serait ensuite mis en place, puis les feuilles 20 et 21 pourvues de leurs pellicules 22, 23 respectives seraient posées et pressées pour leur fixation à la plaquette 19. La pression ferait ainsi en sorte que les bosses 27 rehausseraient les contacts 12 dans les ouvertures 26.

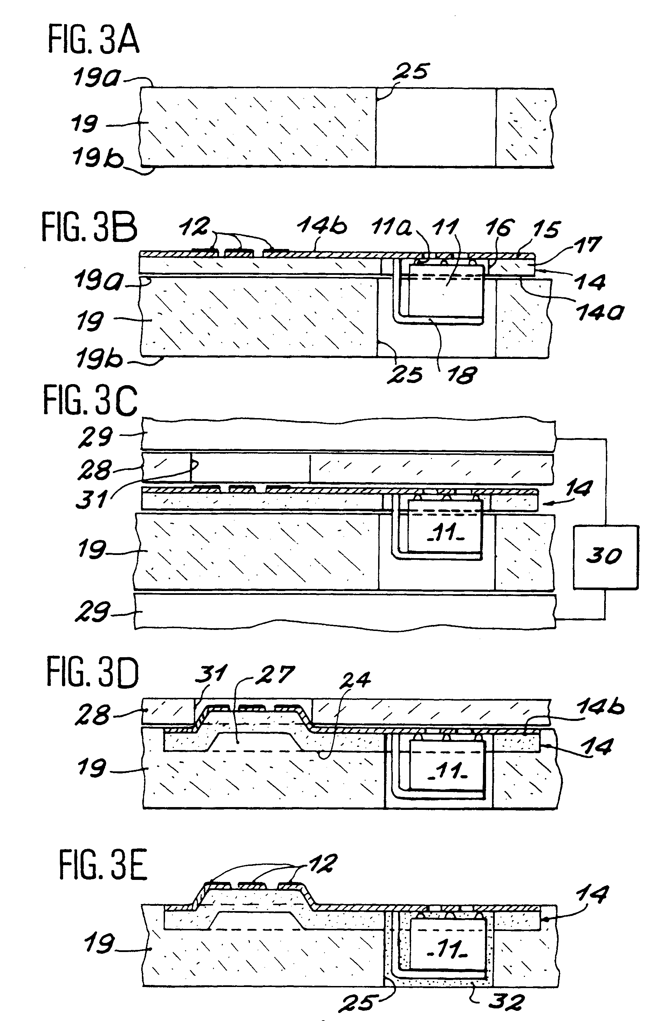

Les figures 3A à 3E illustrent un autre procédé de fabrication de la carte 10 représentée sur les figures 1 et 2.

Les figures 3A à 3E illustrent respectivement des phases intermédiaires du procédé. Au stade initial de la figure 3A, on dispose seulement de la plaquette 19 percée du trou 25 et pourvue de deux faces 19a, 19b uniformément planes et parallèles. A la figure 3B, on a placé sur la face 19a de la plaquette 19 le circuit imprimé 14 pourvu du circuit intégré 11 logé dans la cavité 25. A la figure 3C, on a placé une matrice 28 sur le circuit imprimé 14 et on a enserré l'ensemble de la plaquette 19, du circuit imprimé 14 et de la matrice 28 dans les mâchoires 29 d'une presse chauffante 30. La matrice 28 est une lame métallique uniformément plane et percée d'ouvertures 31 correspondant aux ouvertures 26 de la feuille 20 représentée sur la figure 1. La matrice 28 illustrée a une surface supérieure à celle du circuit imprimé 14. Le métal de la matrice 28 est bon conducteur thermique. Par conséquent, la chaleur dégagée par les mâchoires 29 de la presse 30 va ramollir le matériau de la plaquette 19 au niveau du circuit imprimé 14 et la force de pressage exercée par les mâchoires 29 va enfoncer le circuit imprimé 14 dans la plaquette 19. Cette opération dure jusqu'à ce que la matrice 28 vienne en contact avec la face 19a de la plaquette 19. A titre d'exemple, l'opération de pressage pour une plaquette de PVC ordinaire s'est faite entre 120°C et 140°C établie en dix minutes et maintenue pendant 10 minutes sous une pression de 60 bars. Après avoir enlevé la presse, on obtient ainsi la configuration représentée sur la figure 3D. Dans cette figure, on voit que le pressage a été fait de façon à mettre la face supérieure 14b du circuit imprimé 14 approximativement au niveau de la face 19a de la plaquette 19. Le pressage a ainsi créé la zone de renfoncement 24 dans la face 19a de la plaquette. En même temps, les ouvertures 31 de la matrice 28 ont permis la formation des bosses 27. Il est clair pour l'homme du métier que la hauteur des bosses 27 obtenues par ce procédé dépend de l'épaisseur du circuit imprimé, de l'épaisseur de la matrice 28 et de la température de ramollissement du PVC. Au stade de la figure 3E, on a retiré la matrice 28 et on a rempli la cavité 25 par une substance d'enrobage 32. Il suffit alors de poser et de fixer les feuilles 20 et 21 pourvues de leurs pellicules respectives 22, 23 pour obtenir la carte représentée sur les figures 1 et 2.

Ce procédé offre plusieurs variantes de réalisation. Par exemple, pour éviter de chauffer le circuit intégré 11, il suffirait au stade de la figure 3B de poser seulement le circuit imprimé 14 dépourvu du circuit intégré 11 et de souder ce dernier au stade de la figure 3E, avant l'enrobage. D'autre part, à la figure 3A. on pourrait partir de la plaquette 19 pourvue de la feuille 21 et éventuellement de sa pellicule 23 ou, d'une façon analogue, d'une plaquette monobloc aux deux faces parallèles, dont l'une serait pourvue seulement de la cavité 25. Par ailleurs, la matrice 28 pourrait être une lame plane bonne conductrice thermique ne recouvrant que le circuit imprimé 14. Dans ce cas, il faudrait utiliser un dispositif de contrôle et d'arrêt de la profondeur d'enfoncement du circuit imprimé dans la plaquette 19. L'avantage d'avoir une lame 28 débordant du circuit imprimé, comme illustré, est de se servir de la lame comme moyen de butée contre la face 19a de la plaquette.

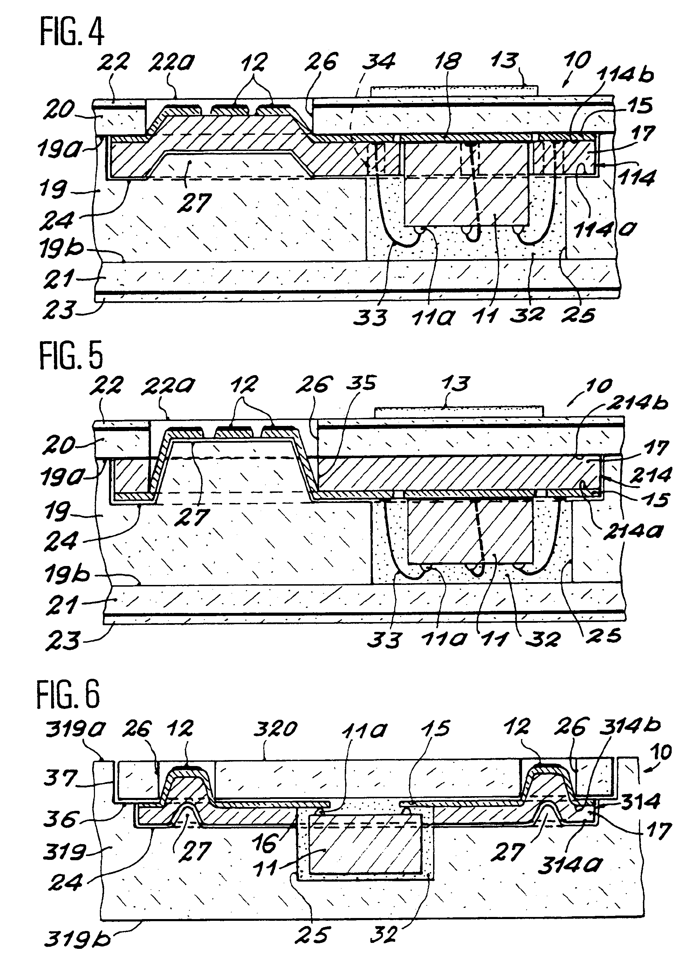

Les figures 4 et 5 illustrent deux variantes de réalisation d'une carte 10 conforme à l'invention, pouvant être fabriquée conformément au procédé qui vient d'être décrit et à ses variantes. Les éléments de la figure 1 qui demeurent inchangés dans les variantes des figures 4 et 5 sont désignés par les mêmes chiffres de référence. Les figures 4 et 5 correspondent à deux variantes de réalisation du circuit imprimé à contacts décalés 12. Dans les figures 4 et 5, le circuit imprimé est conçu pour la connexion par fils, couramment appelée "wire bonding".

Dans la figure 4, le circuit imprimé 114 ne diffère du circuit 14 qu'au niveau du circuit intégré 11. La patte 18 ferme l'ouverture 16 au niveau de la face 114a. Le circuit intégré 11 a sa face arrière collée à la patte 18 et les plots 11a sont connectés aux conducteurs correspondants 15 par des fils 33 traversant le substrat 17 en des trous 34.

Dans la figure 5, le circuit imprimé 11 n'est plus connecté à travers une fenêtre 16 comme dans les figures 1 et 4, de sorte que les conducteurs 15 et les contacts 12 sont disposés sur la face 214a du circuit imprimé 214. Par conséquent, les contacts ne peuvent être accessibles de la face 214b qu'à travers une fenêtre 35 ménagée dans le substrat 17. Chaque bosse 27 doit donc compenser l'épaisseur du substrat 17 et de la feuille 20. Avantageusement. la feuille 20 et/ou le substrat 17 sera aminci pour ne pas exercer de fortes contraintes dans les conducteurs 15 ou dans les contacts 14, au niveau des angles formés par chaque bosse 27.

La figure 6 illustre une autre variante de réalisation d'une carte 10 conforme à l'invention. Selon cette variante, le circuit imprimé 314 n'est plus un circuit imprimé à contacts décalés comme ceux décrits précédemment. C'est un circuit imprimé tel que décrit dans le brevet français précité n° 2 337 381. Selon l'exemple illustré, les deux rangées de contacts 12 sont placées sur deux côtés opposés de l'ouverture 16 ménagée dans le substrat 17 du circuit imprimé 314. Les conducteurs 15 sont placés en porte-à-faux autour de l'ouverture 16 et sont soudés aux plots 11a du circuit intégré 11 selon la technologie TAB. La carte 10 est formée d'une plaquette 319 monobloc, dont la face 31 9a présente de façon coaxiale la cavité 25, la zone 24 et un palier 36. Le circuit imprimé 314 repose sur la zone 24 et le circuit intégré 11 loge dans la cavité 25. La feuille 20 des figures 1 à 5 est ici limitée à un couvercle 320 fixé au palier 36 et coplanaire avec la face 319a de la plaquette 319. Le couvercle 320 présente les deux ouvertures 26 pour donner accès aux deux rangées de contacts 12. Selon l'invention, la zone 24 présente une bosse 27 sous chaque ouverture 26, d'une manière analogue à celle des figures précédentes. Bien entendu, le palier 26 pourrait être supprimé, et la feuille 20 s'étendre sur toute la face 319a de la plaquette 319.

Le procédé de fabrication décrit en référence aux figures 1 et 3A à 3E pourrait également s'appliquer selon la seconde variante mentionnée. En effet, l'ensemble de la plaquette 19 et des feuilles 20 et 21 de la carte représentée sur la figure 1 constituerait, à la figure 3A, la plaquette nue 319 de la figure 6. Dans le cas de la carte 10 illustrée à la figure 6, formée seulement de la plaquette monobloc 319 pourvue du palier 36 et du couvercle 20, il est clair que l'état initial correspondant à la figure 3A serait la plaquette monobloc 319 pourvue de sa cavité 25 entourée d'un domaine de renfoncement 37 ayant la profondeur du palier 36 et ayant la surface de ce palier ajoutée à celle de la face 314b du circuit imprimé 314. La zone 24 et ses bosses 27 seraient formées lors du pressage du circuit imprimé jusqu'à ce que la face supérieure 314b du circuit imprimé 314 soit approximativement coplanaire avec le palier 36. Le domaine 37 précité aurait évidemment la surface de la face 319a si la feuille 20 s'étalait sur cette face.

## Revendications

1. Procédé de fabrication d'une carte à microcircuits électroniques (10) qui comprend un circuit imprimé (14,114,214,314) dont une face (14a,114a,214a, 314a) porte un circuit intégré (11) et l'autre face (14b,114b,214b,314b) présente des contacts (12) ; une plaquette (19,319) en matériau plastique dont une première face (19a,319a) présente une zone (24) de renfoncement pour l'emplacement du circuit imprimé (14,114,214,314) ladite zone étant recouverte par ce circuit imprimé, et une cavité (25) pour loger le circuit intégré (11) ; et une feuille (20,320) recouvrant au moins ledit circuit imprimé et donnant accès aux contacts (12) par au moins une ouverture (26) ; ladite zone (24) de renfoncement comportant une bosse (27) sous chacune des ouvertures (26) de la feuille (20,320), et chaque bosse (27) ayant une hauteur telle que lesdits contacts (12) sont approximativement coplanaires avec une face extérieure (22a) de la carte ;
le procédé comprenant les étapes consistant à :
- pratiquer ladite cavité (25) dans un domaine (37) uniformément plan de ladite première face (19a,319a) de la plaquette (19,319) ;
- disposer le circuit imprimé sur ladite première face de la plaquette ;
- disposer, sur ladite autre face (14b,114b,214b,314b) du circuit imprimé présentant lesdits contacts (12), une matrice (28) formée d'une lame métallique uniformément plane, couvrant au moins ledit circuit imprimé et pourvue d'au moins une ouverture correspondant auxdits contacts (12) ;
- chauffer ladite plaquette à une température de moulage ;
- presser ensemble la plaquette, le circuit imprimé et la matrice jusqu'à ce que ladite autre face (14b,114b,214b,314b) du circuit imprimé soit sensiblement coplanaire avec ledit domaine (37) de la plaquette, créant ainsi dans la plaquette ladite zone (24) de renfoncement et ladite bosse (27) sous chaque ouverture de la matrice (28) ;
- retirer la matrice (28) ; et
- disposer, sur ladite autre face (14b,114b,214b;324b) du circuit imprimé présentant lesdits contacts (12), ladite feuille (20,320).

2. Procédé selon la revendication 1, dans lequel ladite cavité (25) traverse la plaquette (19) sur toute son épaisseur et on rapporte le circuit intégré (11) après pressage en l'introduisant dans ladite cavité (25) à partir d'une seconde face (19b) de la plaquette, puis en le reliant électriquement au circuit imprimé.

3. Procédé selon la revendication 2, dans lequel on relie électriquement le circuit intégré au circuit imprimé au moyen de fils.

4. Procédé selon l'une quelconque des revendications précédentes, dans lequel, après pressage, on remplit un espace entourant le circuit intégré dans la cavité (25) par une substance (32) d'enrobage.

5. Procédé selon l'une quelconque des revendications 1 à 4, dans lequel le circuit imprimé comporte un substrat (17) isolant portant, sur une face, des conducteurs (15), une première face des conducteurs tournée vers l'extérieur du circuit imprimé coopérant avec le circuit intégré, tandis qu'une second face tournée vers l'intérieur du circuit imprimé porte les contacts (12) dans une région du substrat présentant une fenêtre (35), I'opération de pressage s'effectuant de façon que ladite bosse (27) traverse cette fenêtre et fasse saillir au-delà du circuit imprimé jusqu'à ladite face extérieure de la carte.

## Patentansprüche

1. Verfahren zur Herstellung einer Karte (10) mit elektronischen Mikroschaltungen, die eine gedruckte Schaltung (14, 114, 214, 314) aufweist, deren eine Seite (14a, 114a, 214a, 314a) eine integrierte Schaltung (11) trägt und deren andere Seite (14b, 114b, 214b, 314b) Kontakte (12) aufweist; ein Plättchen (19, 319) aus Kunststoffmaterial, von dem eine erste Seite (19a, 319a) einen ausgetieften Bereich (24) für die Anordnung der gedruckten Schaltung (14, 114, 214, 314), wobei der Bereich von dieser gedruckten Schaltung überdeckt wird, und einen Hohlraum (25) zum Einsetzen der integrierten Schaltung (11) aufweist; und eine Folie (20, 320), die wenigstens die gedruckte Schaltung überdeckt und durch wenigstens eine Öffnung (26) einen Zugriff auf die Kontakte (12) zuläßt; wobei der ausgetiefte Bereich (24) unter jeder der Öffnungen (26) der Folie (20, 320) einen Vorsprung (27) aufweist und jeder dieser Vorsprünge (27) eine Höhe besitzt, derart, daß die Kontakte (12) angenähert koplanar zu einer Außenseite (22a) der Karte sind;
wobei das Verfahren die folgenden Schritte umfaßt:
- Vorsehen des Hohlraums (25) in einem gleichmäßig ebenen Bereich (37) der ersten Seite (19a, 319a) des Plättchens (19, 319);
- Anordnen der gedruckten Schaltung auf der ersten Seite des Plättchens;
- Anordnen einer aus einem gleichmäßig ebenen Metallplättchen gebildeten Matrize (28) auf der anderen Seite (14b, 114b, 214b, 314b) der gedruckten Schaltung mit den Kontakten (12), wobei die Matrize (28) wenigstens die gedruckte Schaltung abdeckt und mit wenigstens einer den Kontakten (12) entsprechenden Öffnung versehen ist;
- Erwärmen des Plättchens auf eine Schmelztemperatur;
- Pressen der Einheit aus Plättchen, der gedruckten Schaltung und der Matrize, bis die andere Seite (14b, 114b, 214b, 314b) der gedruckten Schaltung im wesentlichen koplanar zum genannten Bereich (37) des Plättchens ist, um so im Plättchen den ausgetieften Bereich (24) und den Vorsprung (27) unter jeder Öffnung der Matrize (28) zu erzeugen;
- Abnehmen der Matrize (28); und
- Anordnen der Folie (20, 320) auf der anderen Seite (14b, 114b, 214b; 324b) der gedruckten Schaltung mit den Kontakten (12).

2. Verfahren nach Anspruch 1, bei welchem der Hohlraum (25) das Plättchen (19) über seine gesamte Dicke durchsetzt und die integrierte Schaltung (11) nach dem Pressen eingesetzt wird, indem sie ausgehend von einer zweiten Seite (19b) des Plättchens in den Hohlruam (25) eingeführt und dann elektrisch mit der gedruckten Schaltung verbunden wird.

3. Verfahren nach Anspruch 2, bei welchem die integrierte Schaltung mittels Drähten elektrisch mit der gedruckten Schaltung verbunden wird.

4. Verfahren nach einem der vorhergehenden Ansprüche, bei welchem ein die integrierte Schaltung in dem Hohlraum (25) umgebender Raum mit einer Auskleidungssubstanz (32) gefüllt wird.

5. Verfahren nach einem der Ansprüche 1 bis 4, bei welchem die gedruckte Schaltung ein isolierendes Substrat (17) aufweist, das auf einer Seite Leiter (15) aufweist, wobei eine erste Seite der Leiter nach außerhalb der gedruckten Schaltung gedreht ist, die mit der integrierten Schaltung zusammenwirkt, während eine ins Innere der gedruckten Schaltung gedrehte, zweite Seite die Kontakte (12) in einem Bereich des Substrats mit einem Fenster (35) trägt, wobei die Preßoperation derart durchgeführt wird, daß der Vorsprung (27) dieses Fenster durchsetzt und jenseits der gedruckten Schaltung bis zur Außenseite der Karte hinausragt.

## Claims

1. A method for the manufacture of a card with electronic microcircuits (10) comprising a printed circuit (14, 114, 214, 314), one face (14a, 114a, 214a,314a) of which carries an integrated circuit (11) and the other face (14b, 114b, 214b, 314b) of which has contacts (12); small plate (19, 319) of plastics material, a first face (19a, 319a) of which has a recessed zone (24) for the placement of the printed circuit (14, 114, 214, 314), said zone being covered by this printed circuit, and a cavity (25) to house the integrated circuit (11); and a sheet (20, 320) covering at least said printed circuit and giving access to the contacts (12) through at least one opening (26); said recessed zone (24) comprising a boss (27) beneath each of openings (26) of the sheet (20, 320), and each boss (27) having a height such that said contacts (12) are approximately coplanar with an exterior face (22a) of the card;
the method comprising the steps consisting of:
- providing said cavity (25) in a uniformly flat area (37) of said first face (10a, 319a) of the small plate (19, 319);
- arranging on said first face of the small plate the printed circuit;
- arranging on said other face (14b, 114b, 214b, 314b) of the printed circuit having said contacts (12) a matrix (28) formed of a uniformly flat metal lamina covering at least said printed circuit and provided with at least one opening corresponding to said contacts (12);
- heating said small plate to a moulding temperature;
- pressing together the small plate, the printed circuit and the matrix until said other face (14b, 114b, 214b, 314b) of the printed circuit is substantially coplanar with said area (37) of the small plate (19), thus creating in the small plate said recessed zone (24) and said boss (27) beneath each opening of the matrix; withdrawing the matrix (28); and
- arranging, on said other face (14b, 114b, 214b; 324b) of the printed circuit having said contacts (12), said sheet (20, 320).

2. A method according to Claim 1, in which said cavity (25) crosses the small plate (19) over its entire thickness and the integrated circuit (11) is added after pressing by introducing it into said cavity (25) from second face (19b) of the small plate, then by connecting it electrically to the printed circuit

3. A method according to Claim 2, in which the integrated circuit is connected electrically to the printed circuit by means of wires.

4. A method according to any one of the preceding claims, in which, after pressing, a space surrounding the integrated circuit in the cavity (25) is filled by a coating substance (32).

5. A method according to any one of Claims 1 to 4, in which the printed circuit comprises an insulating substrate (17) carrying, on one face, conductors (15), a first face of the conductors turned towards the exterior of the printed circuit cooperating with the integrated circuit, whilst a second face turned towards the interior of the printed circuit carries the contacts (12) in a region of the substrate having a window (35), the pressing operation being carried out such that said boss (27) crosses said window and projects beyond the printed circuit up to said exterior face of the card.
